# EUROPEAN PATENT APPLICATION

(11) **EP 2 248 932 A1**
(43) Date of publication of application: **10.11.2010**
(21) Application number: 09711620.6
(22) Date of filing: 16.02.2009
(51) Int. Cl.: C30B 29/06, C30B 15/20

(54) **SILICON MONOCRYSTAL GROWTH METHOD**

(30) Priority: 18.02.2008 JP 2008036679
(71) Applicant: SUMCO CORPORATION, Tokyo 105-8634 (JP)
(72) Inventor: FUJIWARA, Toshiyuki, Tokyo 105-8634 (JP); HOSOI, Takehiko, Tokyo 105-8634 (JP); NAKAMURA, Tsuyoshi, Tokyo 105-8634 (JP)
(74) Representative: Hössle Patentanwälte Partnerschaft
(86) International application number: PCT/JP2009/052484
(87) International publication number: WO 2009/104532

(57) **Abstract**

Silicon monocrystal growth is ended before a liquid surface of a melt reaches a corner portion of a quartz crucible, and thus dislocation of a silicon monocrystal can be reduced and reduction in yield can be prevented.

## Description

### Field of the invention

The present invention relates to a silicon monocrystal growth method, specifically a silicon monocrystal growth method capable of reducing an occurrence ratio of dislocation in a silicon monocrystal.

### Description of related Art

When a silicon monocrystal is produced in a Czochralski process (CZ process), solid silicon material is heated and melted in a quartz crucible, and thereby a melt (silicon melt) is formed. Subsequently, a seed crystal is immersed in the melt, and then pulled up while being rotated. Thereby, a silicon monocrystal is grown beneath the seed crystal (Related Art 1, for example).
The seed crystal used herein has a diameter of several tens mm or less. In a general crystal growth method, a diameter is increased from a neck portion to a predetermined diameter greater than the diameter of the seed crystal (diameter increasing portion). Thereafter, a straight body portion (body portion) is formed having a constant diameter for a predetermined length. Subsequently, a diameter decreasing portion is formed, and then a silicon monocrystal is cut off from the melt. The neck portion is a portion that removes dislocation which is introduced when the seed crystal is immersed in the melt and the like. The diameter decreasing portion is a portion that prevents occurrence of dislocation caused by a sudden temperature change when the growing silicon monocrystal is cut off from the silicon melt.

The obtained straight body portion of the silicon monocrystal is ground on an external periphery and sliced, and thereby a wafer is produced. The wafer is then polished. Subsequently, the wafer is heat-treated or epitaxially grown, as required. Thereby, a silicon wafer is produced as a semiconductor device material. It is required, for example, that the silicon wafer be free from dislocation and slip, in order to prevent damage due to heat stress at a time of heat treatment in a semiconductor device production process.

[Related Art 1] Japanese Patent Laid-open Publication No. H11-278993

### Summery of the invention

### Problem to be solved by the invention

In the silicon monocrystal production process employing the CZ process, however, dislocation sometimes occurs proximate to a growth interface of a silicon monocrystal growing free from dislocation. Once dislocation occurs, dislocation increases in the growth area thereafter, thus preventing the silicon monocrystal from being used as a product.
A slip plane to which dislocation is likely to transfer is a {111} plane in case of a silicon monocrystal. A silicon wafer used as a semiconductor device material generally has a (100) plane substantially coinciding with a cross section (growth interface) of a straight body portion. In this case, the {111} plane is provided at an angle of approximately 54.7 degrees from the growth interface. Thus, even in a portion grown free from dislocation at the time of dislocation, slip and dislocation are inherent in a portion longer than a diameter of the straight body portion due to slip of dislocation, depending on a location within a plane where dislocation occurs. Consequently, the portion cannot be used as a product.

When dislocation occurs at an early stage of crystal growth, the growth can be stopped. Then, an obtained silicon monocrystal can be melted again in a melt, and pull-up can be resumed from the beginning. Thus, the problem is insignificant. When dislocation occurs in a late process of crystal growth, however, the problem is significant. Specifically, due to a limited amount of the melt remaining in a quartz crucible, it takes a long time to melt the grown crystal, thus significantly hampering productivity. It is necessary to stop crystal growth so as to remove the silicon monocrystal, or to continue the growth ignoring the dislocation.
An increase in diameter of silicon monocrystals has recently been facilitated, and silicon monocrystals having a diameter of 300 mm are produced. Further, silicon monocrystals having a diameter of 450 mm are expected to be produced. With the increase in diameter, however, defect portions associated with dislocation increase, thus adversely affecting a yield of silicon monocrystal production. Causes of the occurrence have yet to be known sufficiently.

As a result of intense research, the inventors have focused on a structure of a quartz crucible. Specifically, a general quartz crucible has a structure including a peripheral wall portion (cylindrical peripheral side portion of a quartz crucible), a bottom portion, and a corner portion, the peripheral wall portion having a constant external diameter, the bottom portion having a bulging shape and being provided with an external surface having a predetermined curvature radius, the corner portion integrally connecting the peripheral wall portion and the bottom portion and being provided with an external surface having a smaller curvature radius than the external surface of the bottom portion. Based on results of confirmation tests at a timing of dislocation, the inventors have found that dislocation of silicon monocrystals is remarkable when a liquid surface of a melt reaches the corner portion and when the melt reaches an intermediate position of the corner portion having an arc shape from a vertical cross-sectional view. The inventors have thus confirmed that, when at least a straight body portion of a silicon monocrystal is completely pulled up before the liquid surface of the melt reaches a height at which dislocation is remarkable, dislocation can be reduced and reduction in yield of silicon monocrystals can be prevented. Thereby, the present invention has been completed. It is further preferable when an entire silicon monocrystal is pulled up before the liquid surface of the melt reaches the height at which dislocation is remarkable.

After performing further research, the inventors have found that, in order to deal with adverse effects of employing the preventive measures for dislocation, a silicon material for crystallization only has to be refilled into a quartz crucible immediately after a silicon monocrystal is grown, so as to resume the growth. Thereby, the present invention has been completed. Examples of the adverse effects may include reduction in productivity associated with shortening of silicon monocrystals, reduction in yield due to a large amount of the melt remaining in the quartz crucible after pull-up, and the like.

The present invention provides a silicon monocrystal growth method capable of reducing dislocation of a silicon monocrystal during growth, regardless of a diameter of the silicon monocrystal, and capable of preventing reduction in yield of silicon monocrystal production due to dislocation.
Further, the present invention provides a silicon monocrystal growth method capable of preventing reduction in productivity associated with shortening of a silicon monocrystal due to a preventive measure of dislocation, and reduction in yield associated with an increased amount of a melt remaining in a crucible.

### Means to solve the problem

A first aspect of the invention provides a silicon monocrystal growth method employing a Czochralski process, in which a silicon material for crystallization is filled and melted in a quartz crucible, a seed crystal is immersed in a melt and pulled up while being rotated, a silicon monocrystal is grown beneath the seed crystal, the silicon monocrystal being provided with a straight body portion having a constant diameter. In the method, the quartz crucible is a container including a peripheral wall portion having a constant external diameter; a bulging bottom portion provided below the peripheral wall portion and provided with an external surface having a predetermined curvature radius; and a bulging corner portion provided with an external surface having a smaller curvature radius than the external surface of the bottom portion, and inseparably connecting the peripheral wall portion and the bottom portion. Growth of the silicon monocrystal is started in a state in which a liquid surface of the melt is located in an area of the peripheral wall portion, and growth of the straight body portion of the silicon monocrystal is ended before the liquid surface of the melt reaches the corner portion.

According to the first aspect of the invention, the growth of the silicon monocrystal is started in the Czochralski process, in a state in which the liquid surface of the melt is located in the area of the peripheral wall portion. Thereafter, pulling up of the straight body portion of the silicon monocrystal is ended before the liquid surface of the melt reaches the corner portion. Thereby, dislocation of the silicon monocrystal can be reduced, and thus reduction in yield stemming from the dislocation can be prevented in silicon monocrystal production.

The pulled up silicon monocrystal may be, for example, a monocrystal for a 6-inch wafer, a monocrystal for an 8-inch wafer, a monocrystal for a wafer of 300 mm or larger, and the like. The external diameter of the peripheral wall portion of the quartz crucible is constant along an entire length of the peripheral wall portion. Specifically, the peripheral wall portion is a cylindrical body having a horizontal cross-sectional shape and a cross-sectional area constant along the entire length.
The quartz crucible is deformed at a connecting portion of the cylindrical peripheral wall portion and the corner portion having the predetermined curvature radius. When the melt reaches the area, dislocation tends to occur in the silicon monocrystal which is being pulled up.

As the silicon material for crystallization, solid polycrystalline silicon may be used. A dopant, such as boron (B), phosphorous (P), or the like, may be added in the melt.
The melt in the quartz crucible at the time of start of monocrystal growth may be provided in an amount such that the liquid surface reaches the peripheral wall portion.
The silicon monocrystal may have a shape including, for example, a neck portion (squeezed portion), a diameter increasing portion (upward cone portion), a straight body portion, and a diameter decreasing portion (downward cone portion). The shape may hardly have any neck portion, or may have no diameter decreasing portion.

As the Czochralski process, a magnetic field applied Czochralski pull-up process (MCZ process) may be employed, in place of a general CZ process.
The curvature radius of the external surface of the corner portion of the quartz crucible is 10% to 30% of the external diameter of the peripheral wall portion. The curvature radius of less than 10% is too small, and it is difficult to produce a crucible having an even thickness. When the curvature radius exceeds 30%, the bulging shape of the corner portion is remarkable, and a capacity of the bulging portion is increased. Accordingly, a remaining amount of the melt in the quartz crucible is large at the time of end of silicon monocrystal growth according to the present invention, and thus reduction in yield is noticeable. When the curvature radius of the external surface of the corner portion is 15% to 25% of the external diameter of the peripheral wall portion in particular, evenness of the crucible thickness is not significantly impacted, and the remaining amount of the melt in the quartz crucible is not too much at the time of the end of silicon monocrystal growth.

The curvature radius of the external surface of the bottom portion of the quartz crucible is 80% or greater of the external diameter of the peripheral wall portion. When the curvature radius is less than 80%, the bulge of the bottom portion is large, and thus a capacity of the bulging portion is increased. Accordingly, the remaining amount of the melt in the quartz crucible is large at the time of the end of silicon monocrystal growth according to the present invention, and thus reduction in yield of the silicon monocrystal is noticeable. When the curvature radius of the external surface of the bottom portion is 90% or greater of the external diameter of the peripheral wall portion in particular, the remaining amount of the melt in the quartz crucible is not excessive at the time of the end of silicon monocrystal growth according to the present invention.

The "bulging shape" refers to a shape bulging outward of the quartz crucible.
The "state in which a liquid surface of the melt is located in an area of the peripheral wall portion" represents a status in which the melt in the quartz crucible exceeds the area of the bottom portion and the area of the corner portion, and reaches the area of the peripheral wall portion.
That "growth of the straight body portion of the silicon monocrystal is ended before the liquid surface of the melt reaches the corner portion" represents that the remaining amount of the melt in the quartz crucible is gradually reduced along with silicon monocrystal growth, and that the growth of the straight body portion is ended while the liquid surface stops in the area of the peripheral wall portion. The phrase means that it is acceptable when growth of at least the straight body portion is ended, while the liquid surface is located in the area of the peripheral wall portion. Specifically, cases are included in which the silicon monocrystal is grown to a middle portion of the diameter decreasing portion, or growth of an entire silicon monocrystal is ended, while the liquid surface of the melt exists in the area of the peripheral wall portion.

A second aspect of the invention provides the silicon monocrystal growth method according to the first aspect, wherein a process is repeated at least once in which immediately after the growth of the silicon monocrystal is ended, the silicon material for crystallization is refilled in the quarts crucible; subsequently, the growth of the silicon monocrystal is performed again in the Czochralski process; and the growth of the straight body portion of the silicon monocrystal is ended before the liquid surface of the melt reaches the corner portion.

Taking the preventive measure for dislocation of the silicon monocrystal according to the first aspect shortens a length of the silicon monocrystal that can be pulled up compared with the conventional length, thus reducing productivity of the silicon monocrystal. In order to address the problem, in the second aspect of the invention, the silicon material for crystallization is refilled in the quartz crucible immediately after the growth of the silicon monocrystal (growth of the entire monocrystal) is ended, and then the growth of the silicon monocrystal in the Czochralski process is resumed. Compared with a case in which the preventive measure for dislocation of the first aspect is taken, it is thereby possible to prevent reduction in productivity of the silicon monocrystal associated with shortening of the silicon monocrystal and reduction in yield associated with an increase in the remaining amount of the melt in the crucible, both of which stem from the preventive measure for dislocation. The reduction in yield can be prevented, since when resumption of pulling up is performed a predetermined number of times after the material is refilled, the amount of the melt remaining in the crucible after the growth of the last silicon monocrystal is stopped is substantially the same as the remaining amount of the melt after the silicon monocrystal is pulled up for the first time.

That "immediately after the growth of the silicon monocrystal is ended" represents a time after the growth of the silicon monocrystal is ended and before another process is performed on the silicon monocrystal.
An example of a method of refilling the silicon material for crystallization may be to load polycrystalline silicon in a granular or lump form in the melt. The material is loaded in an amount, such that the liquid surface of the melt is located again in the area of the peripheral wall portion.
That "the growth of the silicon monocrystal is performed again in the Czochralski process" represents that a new seed crystal is immersed in the melt again, and the seed crystal is then pulled up while being rotated, and thereby the silicon monocrystal is grown beneath the seed crystal.

That "the growth of the straight body portion of the silicon monocrystal is ended before the liquid surface of the melt reaches the corner portion" represents that, as pulling up of the silicon crystal proceeds, the growth (pull up) of the straight body portion of the silicon monocrystal is ended before the liquid surface of the melt in the quartz crucible reaches a boundary between the peripheral wall portion and the corner portion. Growth of a portion following the straight body portion (entire monocrystal) may be stopped at the point.
The process of refilling the silicon material for crystallization after the end of monocrystal growth and the process of regrowing the silicon monocrystal thereafter in the Czochralski process may be performed sequentially once each, or repeated for a plurality of times.

A third aspect of the invention provides a silicon monocrystal growth method employing a Czochralski process, in which a silicon material for crystallization is filled and melted in a quartz crucible, a seed crystal is immersed in a melt and pulled up while being rotated, a silicon monocrystal is grown beneath the seed crystal, the silicon monocrystal being provided with a straight body portion having a constant diameter. In the method, the quartz crucible is a container including a peripheral wall portion having a constant external diameter; a bulging bottom portion provided below the peripheral wall portion and provided with an external surface having a predetermined curvature radius; and a bulging corner portion provided with an external surface having a smaller curvature radius than the external surface of the bottom portion, and inseparably connecting the peripheral wall portion and the bottom portion. Growth of the silicon monocrystal is started in a state in which a liquid surface of the melt is located in an area of the peripheral wall portion, and growth of the straight body portion of the silicon monocrystal is ended before the liquid surface of the melt reaches an intermediate position of the corner portion having an arc shape from a vertical cross-sectional view.

According to the third aspect of the invention, the growth of the silicon monocrystal is started in the Czochralski process in the state in which the liquid surface of the melt is located in the area of the peripheral wall portion. Then, pulling up of the straight body portion of the silicon monocrystal is ended before the liquid surface of the melt reaches the intermediate position of the corner portion having an arc shape from a vertical cross-sectional view. Thereby, dislocation of the silicon monocrystal can be reduced, and reduction in yield of silicon monocrystal production due to the dislocation can be prevented. In addition, the silicon monocrystal obtained in one pull up can be longer and larger, compared with the case of the first aspect (case in which the growth of the straight body portion is ended before the liquid surface of the melt reaches the corner portion). The remaining amount of the melt in the quartz crucible after pulling up is reduced for the amount of the increased silicon monocrystal, and thus a yield can be increased in silicon monocrystal production. The increase in the silicon monocrystal can be achieved when the liquid surface at the time of end of pulling up of the crystal is located in an area from the boundary between the peripheral wall portion and the corner portion to the intermediate position of the corner portion of the quartz crucible.

The "vertical cross-sectional view" represents a front view of a cutting plane when the quartz crucible is cut along a perpendicular plane including a center line of the straight body portion (central axis of pulling up and growth of the silicon monocrystal).
That "growth of the straight body portion of the silicon monocrystal is ended before the liquid surface of the melt reaches an intermediate position of the corner portion having an arc shape from a vertical cross-sectional view" represents that as pulling up of the silicon crystal proceeds, growth of the straight body portion is ended before the liquid surface of the melt reaches the intermediate position of the corner portion from a vertical cross-sectional view.
The "intermediate position of the corner portion" is different from an intermediate position of the corner portion in a direction of height of the quartz crucible. Specifically, when the quartz crucible is viewed from a vertical cross section, the corner portion appears as a horizontal pair of arc-shaped members. The "intermediate position of the corner portion having an arc shape from a vertical cross-sectional view" represents an intermediate lengthwise position of the arc on an internal peripheral surface of the corner portion.

A fourth aspect of the invention provides the silicon monocrystal growth method according to the third aspect, wherein a process is repeated at least once in which immediately after the growth of the silicon monocrystal is ended, the silicon material for crystallization is refilled in the quarts crucible; subsequently, the growth of the silicon monocrystal is performed again in the Czochralski process; and the growth of the straight body portion of the silicon monocrystal is ended before the liquid surface of the melt reaches the intermediate position of the corner portion having the arc shape from the vertical cross-sectional view.

Taking the preventive measure for dislocation of the silicon monocrystal according to the third aspect shortens a length of the silicon monocrystal that can be pulled up, thus reducing productivity of the silicon monocrystal. In order to address the problem, in the fourth aspect of the invention, the silicon material for crystallization is refilled in the quartz crucible immediately after the growth of the silicon monocrystal is ended, and then the growth of the silicon monocrystal in the Czochralski process is resumed. Compared with a case in which the preventive measure for dislocation of the third aspect is simply taken, it is thereby possible to prevent reduction in productivity of the silicon monocrystal associated with shortening of the silicon monocrystal and reduction in yield associated with an increase in the remaining amount of the melt in the crucible, both of which stem from the preventive measure.

### Effect of the invention

According to the first aspect of the invention, the growth of the silicon monocrystal is started in the state in which the liquid surface of the melt is located in the area of the peripheral wall portion. Thereafter, the growth of the straight body portion of the silicon monocrystal is ended before the liquid surface of the melt reaches the corner portion. Thereby, dislocation of the silicon monocrystal can be reduced, and thus reduction in yield stemming from the dislocation can be prevented in silicon monocrystal production.

According to the second aspect of the invention, the silicon material for crystallization is refilled in the quartz crucible immediately after the growth of the silicon monocrystal (whole) is ended, and then the growth of the silicon monocrystal is resumed. Compared with the case in which the preventive measure for dislocation of the first aspect is taken, it is thereby possible to prevent reduction in productivity of the silicon monocrystal associated with shortening of the silicon monocrystal and reduction in yield associated with an increase in the remaining amount of the melt in the crucible, both of which stem from the preventive measure for dislocation.

According to the third aspect of the invention, the growth of the silicon monocrystal is started in the state in which the liquid surface of the melt is located in the area of the peripheral wall portion. Then, the growth of the straight body portion is ended before the liquid surface of the melt reaches the intermediate position of the corner portion having the arc shape from the vertical cross-sectional view. Thereby, dislocation of the silicon monocrystal can be reduced, and reduction in yield of silicon monocrystal production due to the dislocation can be prevented. In addition, the silicon monocrystal obtained in one pull up can be longer and larger, compared with the case of the first aspect. Thus, a yield can be increased in silicon monocrystal production for the increased amount.

According to the fourth aspect of the invention, the silicon material for crystallization is refilled in the quartz crucible immediately after the growth of the silicon monocrystal, and then the growth of the silicon monocrystal is resumed. Compared with the case in which the preventive measure for dislocation of the third aspect is taken, it is thereby possible to prevent reduction in productivity of the silicon monocrystal associated with shortening of the silicon monocrystal and reduction in yield associated with an increase in the remaining amount of the melt in the crucible, both of which stem from the preventive measure.

### Brief description of the drawings

Fig. 1 is a vertical cross-sectional view of a crystal growth apparatus performing a monocrystal growth method according to a first embodiment of the present invention;
Fig. 2 is a vertical cross-sectional view of a quartz crucible installed in the crystal growth apparatus performing the monocrystal growth method according to the first embodiment of the present invention;
Fig. 3a is a vertical cross-sectional view of the crystal growth apparatus, illustrating a material loading process of the monocrystal growth method according to the first embodiment of the present invention;
Fig. 3b is a vertical cross-sectional view of the crystal growth apparatus, illustrating a material melting process of the monocrystal growth method according to the first embodiment of the present invention;
Fig. 3c is a vertical cross-sectional view of the crystal growth apparatus, illustrating a seeding process of the monocrystal growth method according to the first embodiment of the present invention;
Fig. 3d is a vertical cross-sectional view of the crystal growth apparatus, illustrating a process of pulling up a silicon monocrystal of the monocrystal growth method according to the first embodiment of the present invention;
Fig. 3e is a vertical cross-sectional view of the crystal growth apparatus, illustrating a status in which pulling up of the silicon monocrystal is ended in the monocrystal growth method according to the first embodiment of the present invention;
Fig. 4 is a vertical cross-sectional view of a quartz crucible installed in a crystal growth apparatus performing a different monocrystal growth method according to the first embodiment of the present invention;
Fig. 5a is a vertical cross-sectional view of a crystal growth apparatus, illustrating a material loading process of a monocrystal growth method according to a second embodiment of the present invention;
Fig. 5b is a vertical cross-sectional view of the crystal growth apparatus, illustrating a material melting process of the monocrystal growth method according to the second embodiment of the present invention;
Fig. 5c is a vertical cross-sectional view of the crystal growth apparatus, illustrating a seeding process of the monocrystal growth method according to the second embodiment of the present invention;
Fig. 5d is a vertical cross-sectional view of the crystal growth apparatus, illustrating a process of pulling up a silicon monocrystal of the monocrystal growth method according to the second embodiment of the present invention;
Fig. 5e is a vertical cross-sectional view of the crystal growth apparatus, illustrating a status in which pulling up of the silicon monocrystal is ended in the monocrystal growth method according to the second embodiment of the present invention;
Fig. 5f is a vertical cross-sectional view of the crystal growth apparatus, illustrating a material reloading process of a monocrystal growth method according to a second embodiment of the present invention; and
Fig. 6 is a histogram illustrating an occurrence ratio of dislocation at a position in a direction of length of a straight body portion in a silicon monocrystal growth process.

### Description of reference numerals

- 16: Quartz crucible
- 18: Peripheral wall portion
- 19: Bottom portion
- 20: Corner portion
- 26: Melt
- 26a: Liquid surface
- 30: Silicon material for crystallization
- C: Seed crystal
- S: Silicon monocrystal
- S3: Straight body portion

### Description of the preferred embodiments

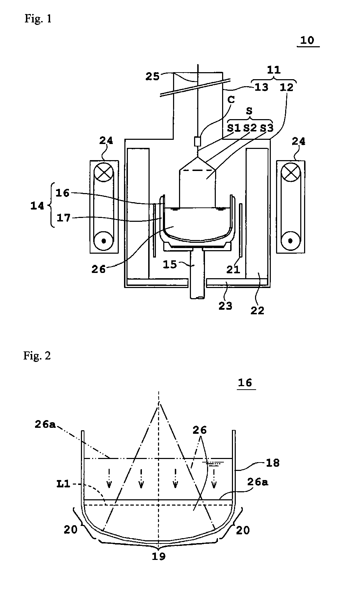

The embodiments of the present invention are specifically explained below. A silicon monocrystal growth method according to a first embodiment is first explained, with reference to Figs. 1 to 4. Production of a silicon monocrystal having a diameter of 300 mm is used as an example in the embodiment.

### First embodiment

A crystal growth apparatus 10 in Fig. 1 is used in the silicon monocrystal growth method according to the first embodiment. The crystal growth apparatus 10 has a hollow cylindrical chamber 11. The chamber 11 has a main chamber 12 and a pull chamber 13, which is connectedly fixed onto the main chamber 12 and has a smaller diameter than the main chamber 12. In a central portion of the main chamber 12, a crucible 14 is fixed onto a rotatable and vertically movable support axis (pedestal) 15. The crucible 14 has a double structure combining an internal quartz crucible 16 and an external graphite crucible 17. The quartz crucible 16 includes a peripheral wall portion 18 having a constant external diameter, and a bulging bottom portion 19 provided below the peripheral wall portion 18 and provided with an external surface having a predetermined curvature radius (100% of the external diameter of the peripheral wall portion). The peripheral wall portion 18 and the bottom portion 19 are inseparably connected by a bulging corner portion 20 provided with an external surface having a smaller curvature radius than the curvature radius of the external surface of the bottom portion 19 (20% of the external diameter of the peripheral wall portion) (Fig. 2).

A resistant heater 21 is provided external to the crucible 14 concentrically to the peripheral wall portion 18. A cylindrical heat-retaining cylinder 22 is provided external to the heater 21 along an internal surface of the main chamber 12. A circular heat-retaining plate 23 is provided on a bottom surface of the main chamber 12. In order to form a horizontal magnetic field, a pair of superconducting magnets 24 are provided opposing each other external to the main chamber 12.
A pull-up axis 25 is suspended through the pull chamber 13 along a central axis of the crucible 14, the pull-up axis 25 being provided concentrically to the support axis 15 and being rotatable and vertically movable. A seed crystal C is mounted to a lower end of the pull-up axis 25.

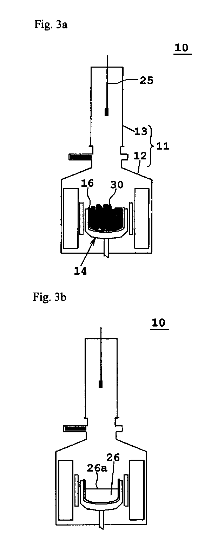

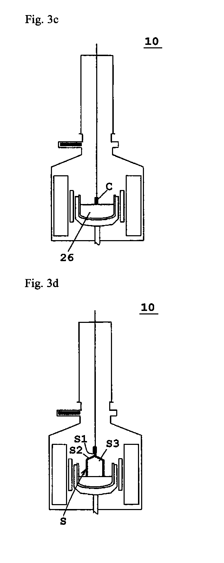

The silicon monocrystal growth method using the crystal growth apparatus 10 is specifically explained below, with reference to Figs. 3a to 3e.
A silicon material for crystallization 30 and boron as impurities is loaded in the crucible 14 (Fig. 3a). A pressure inside the chamber 11 is reduced to 25 Torr, and then an Ar gas is introduced as inert gas at a rate of 100 L/min. Subsequently, the materials loaded in the crucible 14 are melted by the heater 21, and thereby a melt 26 is provided in the crucible 14 (Fig. 3b). At the time (time of start of growth of a silicon monocrystal S), the melt 26 is provided in an amount such that a liquid surface 26a thereof exits in an area of the peripheral wall portion 18 of the quartz crucible 16. Specifically, the liquid surface 26a is located in an upper portion area of the peripheral wall portion 18 (a dashed-two dotted line in Fig. 2). Then, the seed crystal C, which is provided to the lower end of the pull-up axis (wire is also possible) 25, is immersed in the melt 26 (Fig. 3c). While the crucible 14 and the pull-up axis 25 are rotated in mutually reverse directions, the pull-up axis 25 is pulled up in an axial direction, and thereby the silicon crystal S is grown beneath the seed crystal C (Fig. 3d).

In the growth process, dislocation is first removed in a squeezing process, in which a neck portion S1 is formed. In a diameter increasing process subsequent to the squeezing process, a diameter increasing portion S2 is formed. When the diameter stops increasing, a straight body portion S3 starts to be formed. A strength of an applied magnetic field, a rotation rate of the pull-up axis 25, and a rotation rate of the crucible 14 are set and adjusted at the time, so as to achieve desired application of the magnetic field and desired qualities, such as oxygen concentration, of a silicon monocrystal product. Settings for producing the neck portion S1 herein are a magnetic field of 0.4 tesla, a rotation rate of the pull-up axis 25 of 10 rpm, and a rotation rate of the crucible 14 of 0.1 rpm. Thereafter, a power of the heater 21 and a lifting rate of the pull-up axis 25 are changed, and thereby the diameter increasing portion S2 having an upward cone shape is formed. When the diameter of the diameter increasing portion S2 reaches a predetermined diameter (295 mm), the power of the heater 21 and the lifting rate of the pull-up axis 25 are further changed. Then, the process proceeds to pulling up of the straight body portion S3. The power of the heater 21 and the lifting rate of the pull-up axis 25 are adjusted similarly, and then the straight body portion S3 is formed.

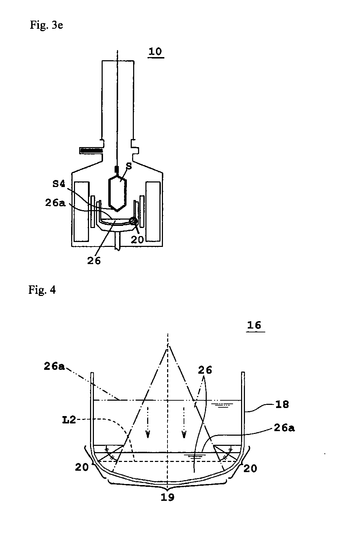

While the straight body portion S3 is being pulled up, the power of the heater 21 is adjusted at a time when a weight of the crystal or a length of the straight body converted from the weight reaches a pre-set weight or length of the straight body, the weight being obtained by a weight detector provided above the pull-up axis 25 or by a diameter measurer and a location detector of the crystal S. Thereby, a diameter decreasing portion S4 having a downward cone shape is gradually formed (Fig. 3e). The growth of the silicon monocrystal S is finally finished at an apex of the downward cone. The length of the straight body is 500 to 2,000 mm, for instance.
The growth of the entire monocrystal including the straight body portion S3 of the silicon monocrystal S is finished at a position before the liquid surface 26a reaches the corner portion 20. Specifically, the position to end the entire monocrystal growth is only 10 mm above an annular boundary line L1 between the peripheral wall portion 18 and the corner portion 20 (Fig. 2). As a result, dislocation of the silicon monocrystal S is reduced, and reduction in yield due to the dislocation can be prevented in silicon monocrystal production.

Alternatively, the growth of at least the straight body portion S3 (entire monocrystal is also possible) may be finished after the liquid surface 26a passes the boundary line L1 of the peripheral wall portion 18 and the corner portion 20 and before the liquid surface 26a reaches an intermediate position L2 of the corner portion 20 from a vertical cross-sectional view of the quartz crucible 16 (Fig. 4). Dislocation of the silicon monocrystal S can be reduced, although the alternative case is less effective than the above-described case in which the liquid surface 26a reaches before the corner portion 20. Compared with the case in which the growth of the silicon monocrystal S is finished before the liquid surface 26a reaches the corner portion 20, a longer and larger silicon monocrystal S can be obtained per one pull-up of the silicon monocrystal S. For the increased amount, a remaining amount of the melt 26 in the quartz crucible 16 is reduced, and thus a yield of silicon monocrystal production can be increased.

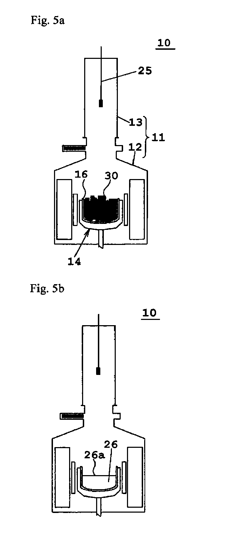

A silicon monocrystal growth method according to a second embodiment of the present invention is explained below with reference to Figs. 5a to 5f.
Features of the silicon monocrystal growth method of the second embodiment are described below. Immediately after growth of the silicon monocrystal S, the silicon material for crystallization 30 is refilled in the quartz crucible 16. Thereafter, the growth of the silicon monocrystal S in the Czochralski process is resumed. The growth of the silicon monocrystal S is finished before the liquid surface 26a reaches the corner portion 20. Then, the processes above are repeated for a predetermined number of times.

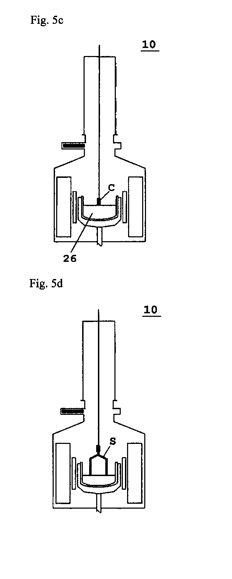

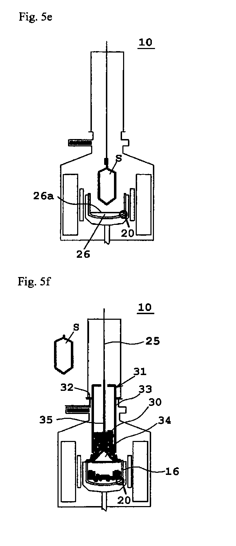

The second embodiment is specifically explained below with reference to Figs. 5a to 5f.
A silicon material for crystallization 30 and boron as impurities is loaded in the crucible 14 (Fig. 5a). A pressure inside the chamber 11 is reduced to 25 Torr, and then an Ar gas is introduced at a rate of 100 L/min. Subsequently, the materials loaded in the crucible 14 are melted by the heater 21, and thereby a melt 26 is provided (Fig. 5b). The melt 26 at the time is provided in an amount such that the liquid surface 26a reaches an area of the peripheral wall portion 18 of the quartz crucible 16. Then, the seed crystal C provided to the lower end of the pull-up axis 25, is immersed in the melt 26 (Fig. 5c). While the crucible 14 and the pull-up axis 25 are rotated, the pull-up axis 25 is pulled up in an axial direction, and thereby the silicon crystal S is grown beneath the seed crystal C (Fig. 5d). In the growth process, the neck portion S1, the diameter increasing portion S2, the straight body portion S3, and the diameter decreasing portion S4 are sequentially formed. The growth of the silicon monocrystal S is then finished (Fig. 5e). The growth of the entire monocrystal including the straight body portion S3 of the silicon monocrystal S is finished at a position before the liquid surface 26a reaches the corner portion 20 (above the boundary line L1 between the peripheral wall portion 18 and the corner portion 20).

Subsequently, the silicon monocrystal S is removed from the pull chamber 13, and then the silicon material for crystallization 30 is refilled in the quartz crucible 16 (Fig. 5f). Thereafter, the growth of the silicon monocrystal S in the Czochralski process is resumed (Figs. 5b to 5f).
The silicon material for crystallization 30 is refilled by a silicon refiller 31 suspended from the pull-up axis 25 in the pull chamber 13. The silicon refiller 31 has a vertically long cylindrical casing 33, a conical lid 34, and open/close stick 35. The cylindrical casing 33 has an entirely open lower end surface and a flange 32 provided externally around an upper end portion. The conical lid 34 is capable of opening and closing the opening of the cylindrical casing 33. The open/close stick 35 has a lower end portion fixed to an apex portion of the conical lid 34, and an upper end portion projecting upward through an insertion hole provided to a middle portion of an upper end surface of the cylindrical casing 33. An upper end of the open/close stick 35 is connected to the lower end of the pull-up axis 25.

Lumps of the silicon material for crystallization 30 are loaded in the cylindrical casing 33, and then, in this state, the conical lid 34 closes the opening of the cylindrical casing 33. In other words, a weight of the silicon material for crystallization 30 exerts a force to push down the conical lid 34. Meanwhile, the weight of the silicon material for crystallization 30 is supported by the pull-up axis 25 through the open/close stick 35. It is thus unlikely that the conical lid 34 is erroneously opened, and that the silicon material for crystallization 30 falls into the quartz crucible 16.
When the silicon material for crystallization 30 is loaded, the pull-up axis 25 is lowered. Thereby, the silicon refiller 31 is gradually lowered in the pull chamber 13, and the flange 32 is hooked to a small diameter portion in which the main chamber 12 and the pull chamber 13 are connected. Thereafter, lowering the pull-up axis 25 lowers only the conical lid 34. Thus, the opening of the cylindrical casing 33 is opened, and the silicon material for crystallization 30 is loaded in the crucible 14. Subsequently, the pull-up axis 25 is pulled up, and thus the silicon refiller 31 is removed from the pull chamber 13. Then, the growth of the silicon monocrystal S is resumed (Fig. 5b and thereafter).

As described above, immediately after the growth of the silicon monocrystal S (whole) is finished, the silicon material for crystallization 30 is refilled in the crucible 14. Then, the growth of the silicon monocrystal S is resumed. It is thereby possible to prevent reduction in productivity of the silicon monocrystal S associated with shortening of the silicon monocrystal S and reduction in yield associated with an increase in the remaining amount of the melt in the crucible, both of which stem from the preventive measure for dislocation. The reduction in yield can be prevented, since the amount of the melt 26 remaining in the quartz crucible 16 after the processes of Fig. 5a to Fig. 5f are repeated and the final growth of the last silicon monocrystal S is stopped, is substantially the same as the remaining liquid amount when the silicon monocrystal is pulled up for the first time.
For the growth of the last silicon monocrystal S, substantially all of the melt 26 in the quartz crucible 16 may be used similar to a conventional manner, and then the silicon monocrystal S having a length similar to a conventional product (for example, about 1,000 mm) may be pulled up. Thereby, although a risk of occurrence of dislocation at a rear end portion (lower end portion) of the silicon monocrystal S is similar to that of the conventional product, the yield may be increased for the increased pull-up amount.

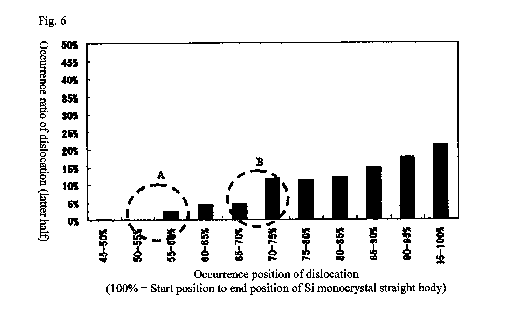

With reference to a histogram of Fig. 6, reasons are explained below why the position to end the monocrystal growth is set to a position before the liquid surface of the melt reaches the corner portion. In a case herein, a silicon monocrystal having a diameter of 300 mm is grown by using a quartz crucible having a same shape as that in the first embodiment and by using an entire melt in the quartz crucible. In the case, dislocation occurs to the silicon monocrystal only in a latter-half portion of the monocrystal growth.
A vertical axis of the histogram represents an occurrence ratio of dislocation in the latter half of crystal growth of the silicon monocrystal. A horizontal axis of the histogram represents an occurrence position of dislocation in a longitudinal direction of a straight body portion, with respect to growth of the straight body portion of the silicon monocrystal. Numerical values on the horizontal axis represent an upper end position (position to start growth) of the straight body portion as 0% and a lower end position (position to end growth) of the straight body portion as 100%. For instance, 45 to 50% represent an area of 45 to 50% of the entire length of the straight body portion from the upper end position of the straight body portion as a reference.

It is demonstrated in the histogram of Fig. 6 that the occurrence ratio of dislocation is substantially increased along with a progress of pulling up of the silicon monocrystal. Further, the occurrence ratio of dislocation is significantly increased at a position exceeding 55% of the straight body length (entire length of the straight body portion) of the silicon monocrystal (portion A in Fig. 6). The position of 55% is a position at which the liquid surface of the melt reaches the corner portion of the quartz crucible.
Furthermore, the occurrence ratio of dislocation is remarkably increased again at a position exceeding 70% of the straight body length of the silicon monocrystal (portion B in Fig. 6). The position of 70% is a position at which the liquid surface of the melt reaches an intermediate position of the arc-shaped corner portion from a vertical cross-sectional view of the quartz crucible.

Thus, it is demonstrated that it is possible to reduce occurrence of a portion unable to be used as a product due to dislocation in growth of the silicon monocrystal in the Czochralski process, when the growth is ended before the position of the liquid surface of the melt reaches the intermediate position of the corner portion of the quartz crucible. It is further demonstrated that it is possible to further reduce occurrence of a portion unable to be used as a product due to dislocation, when the growth is ended before the position of the liquid surface of the melt reaches the corner portion of the quartz crucible.

### Industrial applicability

The present invention is effective in obtaining a silicon wafer used as a substrate of processors, such as an MPU; memory devices, such as a DRAM, a flash memory; and the like, and power devices, such as IGBT and the like.

## Claims

1. A silicon monocrystal growth method employing a Czochralski process, in which a silicon material for crystallization is filled and melted in a quartz crucible, a seed crystal is immersed in a melt and pulled up while being rotated, a silicon monocrystal is grown beneath the seed crystal, the silicon monocrystal being provided with a straight body portion having a constant diameter, wherein
the quartz crucible is a container comprising:
a peripheral wall portion having a constant external diameter;
a bulging bottom portion provided below the peripheral wall portion and provided with an external surface having a predetermined curvature radius; and
a bulging corner portion provided with an external surface having a smaller curvature radius than the external surface of the bottom portion, and inseparably connecting the peripheral wall portion and the bottom portion; and
growth of the silicon monocrystal is started in a state in which a liquid surface of the melt is located in an area of the peripheral wall portion, and growth of the straight body portion of the silicon monocrystal is ended before the liquid surface of the melt reaches the corner portion.

2. The silicon monocrystal growth method according to claim 1, wherein a process is repeated at least once in which immediately after the growth of the silicon monocrystal is ended, the silicon material for crystallization is refilled in the quarts crucible; subsequently, the growth of the silicon monocrystal is performed again in the Czochralski process; and the growth of the straight body portion of the silicon monocrystal is ended before the liquid surface of the melt reaches the corner portion.

3. A silicon monocrystal growth method employing a Czochralski process, in which a silicon material for crystallization is filled and melted in a quartz crucible, a seed crystal is immersed in a melt and pulled up while being rotated, a silicon monocrystal is grown beneath the seed crystal, the silicon monocrystal being provided with a straight body portion having a constant diameter, wherein
the quartz crucible is a container comprising:
a peripheral wall portion having a constant external diameter;
a bulging bottom portion provided below the peripheral wall portion and provided with an external surface having a predetermined curvature radius; and
a bulging corner portion provided with an external surface having a smaller curvature radius than the external surface of the bottom portion, and inseparably connecting the peripheral wall portion and the bottom portion; and
growth of the silicon monocrystal is started in a state in which a liquid surface of the melt is located in an area of the peripheral wall portion, and growth of the straight body portion of the silicon monocrystal is ended before the liquid surface of the melt reaches an intermediate position of the corner portion having an arc shape from a vertical cross-sectional view.

4. The silicon monocrystal growth method according to claim 3, wherein a process is repeated at least once in which immediately after the growth of the silicon monocrystal is ended, the silicon material for crystallization is refilled in the quarts crucible; subsequently, the growth of the silicon monocrystal is performed again in the Czochralski process; and the growth of the straight body portion of the silicon monocrystal is ended before the liquid surface of the melt reaches the intermediate position of the corner portion having the arc shape from the vertical cross-sectional view.
